# EUROPEAN PATENT APPLICATION

(11) **EP 4 553 576 A1**
(43) Date of publication of application: **14.05.2025**
(21) Application number: 23835508.5
(22) Date of filing: 04.07.2023
(51) Int. Cl.: G03F 1/64

(54) **PELLICLE FRAME, PELLICLE AND EXPOSURE ORIGINAL PLATE WITH PELLICLE, METHOD FOR PRODUCING PELLICLE FRAME, LIGHT EXPOSURE METHOD, METHOD FOR MANUFACTURING SEMICONDUCTOR DEVICE, AND METHOD FOR MANUFACTURING LIQUID CRYSTAL DISPLAY PLATE**

(30) Priority: 06.07.2022 JP 2022109319
(71) Applicant: SHIN-ETSU CHEMICAL CO., LTD., Tokyo 1000005 (JP); Nippon Light Metal Company, Ltd., Tokyo 105-0004 (JP)
(72) Inventor: YANASE, Yu, Annaka-shi, Gunma 379-0195 (JP); OSHIMA, Takeshi, Shizuoka-shi, Shizuoka 421-3203 (JP); NAKANO, Koichi, Shizuoka-shi, Shizuoka 421-3203 (JP)
(74) Representative: Röthinger, Rainer
(86) International application number: PCT/JP2023/024702
(87) International publication number: WO 2024/009976

(57) **Abstract**

The present invention is a pellicle frame to be included in a pellicle for photolithography, wherein the pellicle frame is made of pure titanium or a titanium alloy, and has a surface subjected to: a mechanically polishing treatment; an electrolytic degreasing treatment; and a chemically polishing treatment. This provides a pellicle frame with reduced fine dust particles remaining on the surface, and a method for producing a pellicle frame.

## Description

### TECHNICAL FIELD

The present invention relates to a pellicle and a pellicle frame to be attached to a photomask for lithography for preventing dust, and an exposure plate with a pellicle. In addition, the present invention relates to a method for producing a pellicle frame, an exposure method, a method for producing a semiconductor device, and a method for producing a liquid-crystal display panel.

### BACKGROUND ART

The design rule of LSI has become finer to the sub-quarter micron order in recent years, and due to this miniaturization, a wavelength of an exposure light source has become short. That is, the exposure light source has been transferred from g-line (436 nm) and i-line (365 nm) with a mercury lamp to KrF excimer laser (248 nm), ArF excimer laser (193 nm), etc. Further, extreme ultraviolet (EUV) exposure using EUV light with a main wavelength of 13.5 nm has been investigated.

In producing semiconductor devices such as LSI and very LSI or producing liquid-crystal display panels, a semiconductor wafer or a plate for the liquid crystal is irradiated with light to produce a pattern. If dust adheres to a photomask and a reticle for lithography used in this case (hereinafter, collectively referred to as "exposure plate"), there have been problems that this dust absorbs the light or bends the light to deform the transferred pattern or to roughen the edge, and a base is stained black to impair size, quality, appearance, etc.

These operations are commonly performed in a cleanroom, but it is still difficult to keep the exposure plate always clean. Accordingly, commonly applied is a method of attaching a pellicle to a surface of the exposure plate for preventing the dust and then performing the exposure. In this case, a foreign matter does not directly adhere to the surface of the exposure plate but adheres onto the pellicle, and thereby adjusting a focal point on the pattern of the exposure plate during lithography allows the foreign matter on the pellicle to be regardless of the transfer.

A basic configuration of this pellicle is as follows: a pellicle film having a high transmittance relative to the light used for the exposure is stretched above an upper end surface of a pellicle frame composed of a metal such as aluminum; and a gasket for gastight is formed on a lower end surface. An adhesive layer is typically used as the gasket for gastight, and a protective sheet is attached for a purpose of protecting this adhesive layer. The pellicle film is composed of nitrocellulose, cellulose acetate, fluorine polymer, etc., which well transmit the light used for the exposure (such as g-line (436 nm) and i-line (365 nm) with a mercury lamp, KrF excimer laser (248 nm), and ArF excimer laser (193 nm)). Investigated for the EUV exposure is an ultrathin silicon film and a carbon film as the pellicle film.

For the pellicle frame, an aluminum frame has been conventionally used. On the aluminum frame, an anodic oxide film is provided for purposes of corrosion resistance etc. If a surface of the base aluminum frame on which the anodic oxide film is to be provided has protrusions, the protrusions remain even after the anodic oxide film is formed. To prevent this remaining, it is known that the aluminum frame is subjected to a chemical polishing treatment before the anodic oxide film is provided (Patent Document 1).

Meanwhile, a titanium frame is investigated for EUV. Since the titanium frame has high strength and corrosion resistance, the anodic oxide film is unnecessarily provided for a purpose of increasing strength, as for the aluminum frame. Therefore, scratches and burrs on the titanium frame generated in processing are commonly removed by mechanically polishing, which is excellent in cost and productivity compared with chemical polishing.

### CITATION LIST

### PATENT LITERATURE

Patent Document 1: JP 6008784 B

### SUMMARY OF INVENTION

### TECHNICAL PROBLEM

However, the present inventors have found that, even when a cleaning step is repeated over several times after scratches and burrs are removed by the mechanically polishing etc., particles such as titanium powder generated by the mechanically polishing etc. remain on the pellicle frame surface. These particles are recognized as a foreign matter in an inspection step in producing the pellicle, in an inspection step in attaching the pellicle, and in an inspection step in using the pellicle.

Even if the particles are not detected in the above inspection steps as the foreign matter, the particles have a risk of falling from the pellicle frame in using the pellicle due to vibration and EUV irradiation.

The present invention has been made to solve the above problem. An object of the present invention is to provide a pellicle frame with reduced fine dust particles remaining on the surface, and a method for producing a pellicle frame.

### SOLUTION TO PROBLEM

To achieve the above object, the present invention provides a pellicle frame to be included in a pellicle for photolithography, wherein
the pellicle frame is made of pure titanium or a titanium alloy, and has a surface subjected to:
a mechanically polishing treatment;
an electrolytic degreasing treatment; and
a chemically polishing treatment.

The pellicle frame of the present invention as above is excellent in terms of processing ease, a lightweight property, heat resistance, etc. because the pellicle frame is made of titanium or a titanium alloy.

In addition, fine dust particles and organic substances (oil content, scales, adsorbed dust, etc. that adhere to the surface) remaining on the surface are reduced. Hereinafter, the fine dust particles and the organic substances are collectively referred to as "particles". Therefore, the pellicle frame can be prevented from failure of the foreign-matter inspection due to presence of the particles in the inspection step in producing the pellicle etc. For example, it can be prevented that the particles fall from the pellicle frame in the exposure environment etc. to cause the adverse effect during photolithography.

In this case of the pellicle frame, in particle evaluation of immersion in pure water and irradiation with ultrasonic wave for one minute, a number of particles released into the pure water and having a sphere-equivalent diameter of 1 to 15 µm may be 1500 or less per cm² of a surface area of the pellicle frame.

The above yields the pellicle frame with the extremely reduced number of particles on the surface.

In the pellicle frame, unevenness present on an inner surface of the pellicle frame may be 5 µm or less.

Although unevenness on the surface may affect the foreign matter inspection, reducing the unevenness to size (height or depth) of 5 µm or less as above can reduce the effect on the inspection.

In an ion elution test of immersion in pure water at 90°C for three hours and measurement of a concentration of eluted ions, as for elution concentration into 100 ml of the pure water per 50 cm² of a surface area of the pellicle frame,
acetate ion may be 10 ppb or less,
formate ion may be 100 ppb or less,
Cl ion may be 10 ppb or less,
NO₂ ion may be 10 ppb or less,
NO₃ ion may be 10 ppb or less,
SO₄ ion may be 10 ppb or less,
oxalate ion may be 10 ppb or less,
PO₄ ion may be 10 ppb or less, and
NH₄ ion may be 100 ppb or less.

As above, the pellicle frame with reduced ions to be generated can particularly reduce the effect on the exposure environment due to these ions.

In addition, the present invention provides a method for producing a pellicle frame to be included in a pellicle for photolithography, wherein the pellicle frame is produced by subjecting a surface of a pellicle frame made of pure titanium or a titanium alloy to:
a mechanically polishing treatment;
an electrolytic degreasing treatment; and
a chemically polishing treatment.

The method for producing a pellicle frame of the present invention as above can yield the pellicle frame that is excellence in terms of processing ease, a lightweight property, heat resistance, etc., and that has a reduced number of remaining particles such as the fine dust particles and the organic substances on the surface. Consequently, the producing method can prevent failure in the inspection step and the adverse effect during lithography caused by the particles.

In this case, the mechanically polishing treatment may include a magnetic polishing treatment or a barrel polishing treatment, or
the mechanically polishing treatment may be constituted by only a combination of the magnetic polishing treatment and the barrel polishing treatment.

The above method can further reduce the fine dust particles to remain on the surface of the pellicle frame.

The magnetic polishing treatment may be performed by:
using a bar-shaped magnetic medium made of SUS in cleaning water in which the pellicle frame is immersed.

The polishing treatment performed in cleaning water (solvent) by using the magnetic medium as above rapidly disperses powder such as titanium, even if generated by polishing, into the solvent to remarkably reduce the fine dust to remain on the surface.

The chemically polishing treatment may include
a chemical polishing treatment or an electrolytic polishing treatment.

The method as above can effectively remove the particles adhering to the surface.

In addition, the present invention provides a pellicle for photolithography including:
a pellicle frame; and
a pellicle film stretched on the pellicle frame,
wherein the pellicle frame is the above pellicle frame.

In addition, the present invention provides an exposure plate with a pellicle, including:
an exposure plate; and
a pellicle attached to the exposure plate,
wherein the pellicle is the above pellicle.

The pellicle and the exposure plate with a pellicle of the present invention as above can yield an extremely reduced number of the particles adhering to the surface of the pellicle frame and can prevent the adverse effect in the inspection step and during photolithography.

In addition, the present invention provides an exposure method including a step of performing exposure using the above exposure plate with a pellicle.

In addition, the present invention provides a method for producing a semiconductor device, the method including a step of performing exposure using the above exposure plate with a pellicle.

In addition, the present invention provides a method for producing a liquid-crystal display panel, the method including a step of performing exposure using the above exposure plate with a pellicle.

The exposure method etc. of the present invention as above can yield an extremely reduced number of the particles adhering to the surface of the pellicle frame and can prevent the adverse effect during photolithography such as falling of the particles from pellicle frame in the exposure environment.

### ADVANTAGEOUS EFFECTS OF INVENTION

The present invention can reduce the fine dust particles to remain on the pellicle frame surface. Further, the present invention can remove the particles, even if generated by the mechanical polishing etc. to adhere to the pellicle frame surface, by performing the mechanical polishing etc. and then the chemically polishing treatment, and can reduce the particles having the risk of falling thereafter. Particularly, the present invention can provide the method for producing a pellicle frame with height or depth of the unevenness reduced to 5 µm or less with good foreign-matter inspectability.

### BRIEF DESCRIPTION OF DRAWING

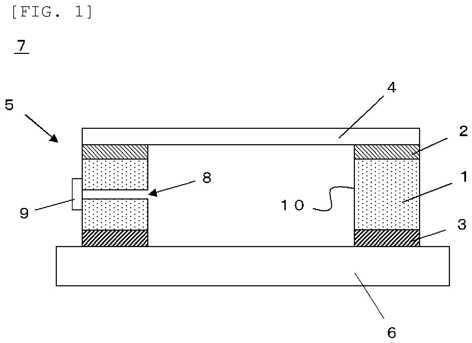

FIG. 1 is a schematic view of an example of the pellicle frame, the pellicle, and the exposure plate with a pellicle of the present invention.

### DESCRIPTION OF EMBODIMENTS

Hereinafter, embodiments of the present invention will be described with reference to the drawing, but the present invention is not limited thereto.

As noted above, examples of the pellicle frame include those made of titanium, and scratches and burrs on the surface are commonly removed by the mechanically polishing, but it has been found that the particles remain on the surface and consequently cause risks of failure in the inspection steps and the adverse effect during photolithography. The present inventors have made earnest study to find that a number of particles on the surface can be remarkably reduced to prevent the above problems with a pellicle frame made of pure titanium or a titanium alloy and having a surface subjected to a mechanically polishing treatment, an electrolytic degreasing treatment, and a chemically polishing treatment. This finding has led to completion of the present invention.

FIG. 1 is a view illustrating an example of the pellicle frame of the present invention, and also illustrating the pellicle and the exposure plate with a pellicle of the present invention. The entirety of FIG. 1 is a view illustrating the exposure plate with a pellicle.

First, the entire configuration will be described. On the pellicle frame of the present invention (hereinafter, which may be simply referred to as "frame") 1, a film-side adhesive 2 is provided on the upper end surface, and meanwhile, a mask-side adhesive 3 is provided on the lower end surface. A pellicle film 4 is stretched above the pellicle frame 1 via the film-side adhesive 2 to constitute a pellicle 5 of the present invention.

The pellicle 5 is attached to an exposure plate (a photomask or a reticle) 6 via the mask-side adhesive 3 on the pellicle frame 1 to constitute an exposure plate 7 with a pellicle of the present invention.

Hereinafter, each part will be described in detail.

The pellicle frame 1 may be any having a frame shape, and the shape corresponds to a shape of a photomask to which the pellicle 5 is attached. The shape is typically a quadrangular (rectangular or square) frame shape.

As noted above, the pellicle frame 1 has a surface to provide the pellicle film 4 (here, referred to as "upper end surface") and a surface to face the photomask in attaching to the photomask (here, referred to as "lower end surface").

A material of the pellicle frame 1 is pure titanium or a titanium alloy, which is excellence from the viewpoints of processing ease, a lightweight property, heat resistance, and improvement of inspectability.

A size of the pellicle frame 1 is not particularly limited, but because a height of the pellicle for EUV is limited to 2.5 mm or less, a thickness of the pellicle frame 1 for EUV is less than 2.5 mm, which is smaller than the limitation.

The thickness of the pellicle frame 1 for EUV is preferably 1.5 mm or less with considering thicknesses of the pellicle film 4, the mask adhesive 3, etc.

On a side surface of the pellicle frame 1, a tool hole (not illustrated) used for handling or releasing the pellicle 5 from the photomask is typically provided. As for a size of the tool hole, a width (diameter in a case of a circular shape) in a thickness direction of the frame 1 is 0.5 to 1.0 mm. A shape of the hole is not limited, and may be circular or rectangular.

On the frame 1, a vent part 8 for relaxing change in pressure between an inside and an outside of the pellicle 5 is provided. A shape and the number of the vent part 8 are not limited. A notch part may be provided on the upper end surface or the lower end surface of the frame 1 for the vent part.

On the vent part 8, a filter 9 may be provided in order to prevent entering of a foreign matter into the pellicle 2. A location to provide the filter 9 is not limited, and includes an inner side of the pellicle frame 1, an inside of the vent part 8, and an outside of the pellicle frame 1. In FIG. 1, the filter 9 is provided outside the pellicle frame 1.

For a conventional pellicle frame made of titanium, a surface treatment therefor is only a mechanically polishing treatment at most, but the surface of the pellicle frame 1 of the present invention is subjected to not only the mechanically polishing treatment but also an electrolytic degreasing treatment and a chemically polishing treatment (specific examples of these treatments will be described later). These treatments yield high quality with remarkably reduced particles on the surface.

Fine dust particles etc. adhering to the pellicle frame 1 can be evaluated by, for example, measuring the number of particles in immersing the pellicle frame 1 in pure water. The number of particles that are released into pure water by irradiating the pellicle frame 1 with ultrasonic wave in pure water for one minutes and that have a sphere-equivalent diameter of 1 to 15 µm is particularly preferably 1500 or less per cm² of the surface area of the pellicle frame 1. With such a low value, a risk of the adverse effect in the inspection step due to the fine dust particles etc. adhering to the pellicle frame 1 can be remarkably reduced. The number of particles is more preferably 1200 or less, and further preferably 1000 or less. Of course, the smaller number of particles is more preferable. The number is extremely preferably zero.

Condition examples of the ultrasonic wave irradiation include an oscillating frequency of 38 kHz and an irradiation time of one minute.

As a method for measuring the number of particles, measurement with an in-liquid particle counter is performed, for example.

Ions generated from the pellicle frame 1 can be evaluated by, for example, an ion elution test in which the pellicle frame 1 is immersed in pure water at 90°C for three hours and concentrations of eluted ions are measured. In this evaluation, as for elution concentration into 100 ml of the pure water per 50 cm² of a surface area of the pellicle frame 1, preferably acetate ion is 10 ppb or less, formate ion is 100 ppb or less, Cl ion is 10 ppb or less, NO₂ ion is 10 ppb or less, NO₃ ion is 10 ppb or less, SO₄ ion is 10 ppb or less, oxalate ion is 10 ppb or less, PO₄ ion is 10 ppb or less, and NH₄ ion is 100 ppb or less. With such low values, the effect on the exposure environment by the ions generated from the pellicle frame is particularly reduced. Smaller values of this elution concentration of the ions are more preferable. The concentrations are extremely preferably 0 ppb.

As a method for measuring the elution concentration of the ions, ion chromatography is used, for example.

If unevenness, namely steps having a size (depth or height) of more than 0 µm, is present on the inner surface 10 of the pellicle frame 1, the size is preferably 5 µm or less. When the unevenness has such a small size, the effect on the foreign-matter inspection can be reduced. Of course, no step (a case where the unevenness size is 0 µm) is extremely preferable.

On the upper end surface of the pellicle frame 1 as above, the film-side adhesive 2 is provided. A material of the film-side adhesive 2 is not limited, and known materials such as a silicone adhesive and an acrylic adhesive may be used. To strongly hold the pellicle film 4, an adhesive having a large adhesion force is preferable. A shape of the film-side adhesive 2 is not limited, and may be subjected to a planarization process. A thickness of a layer of the film-side adhesive 2 is not particularly limited, but preferably 0.5 mm or less because the height of the pellicle 5 is basically limited to 2.5 mm.

On the lower end surface of the pellicle frame 1, the mask-side adhesive 3 to be attached to the photomask is formed. A material of the mask-side adhesive 3 is not limited, and known materials such as a silicone adhesive and an acrylic adhesive may be used. A shape of the mask adhesive 3 is not particularly limited, and may be subjected to a planarization process. A thickness of a layer of the mask-side adhesive 3 is not particularly limited, but preferably 0.5 mm or less because the height of the pellicle 5 is limited to 2.5 mm.

In typical, a protective cover (not illustrated) so as to cover the film-side adhesive 2 and the mask-side adhesive 3 for protecting these adhesives may be provided. A material of the protective cover is not particularly limited, and polyethylene terephthalate (PET), polytetrafluoroethylene (PTFE), tetrafluoroethylene-perfluoroalkyl vinyl ether copolymer (PFA), polyethylene (PE), polycarbonate (PC), polyvinyl chloride (PVC), polypropylene (PP), etc. may be used, for example. As necessary, a releasing agent such as a silicone releasing agent and a fluorine releasing agent may be applied on the surface as a releasing layer. Applying the releasing agent facilitates to release the protective cover from the aforementioned adhesives 2 and 3. A shape of the protective cover is not limited, and may have any shape that can completely cover the adhesives 2 and 3. The shape of the protective cover may be changed between the sides of the film-side adhesive 2 and the mask-side adhesive 3. In releasing the protective cover, a grip part may be provided on a part of the protective cover for facilitating gripping of the protective cover.

A material of the pellicle film 4 is not limited, but preferably a material having a high transmittance with a wavelength of the exposure light source and having high light resistance. For example, an ultrathin silicon film, a carbon film, etc. are used for EUV exposure. Examples of the carbon film include a film of graphene, diamond-like carbon, carbon nanotube, etc. When it is difficult to singly handle the pellicle film, a pellicle film supported on a frame such as silicone may be used. In this case, the frame region and the pellicle frame 1 can be adhered to easily produce the pellicle 5.

The pellicle 5 of the present invention has functions of not only the protective member to inhibit adhesion of a foreign matter on the exposure plate 6 in the exposure apparatus but also a protective member for protecting the exposure plate 6 during storage of the exposure plate 6 or during transport of the exposure plate 6.

Examples of a method for attaching the pellicle 5 to the exposure plate 6 such as the photomask to produce the exposure plate with a pellicle 7 include the aforementioned method of adhesion with the mask adhesive, an electrostatic adsorption method, and a mechanically fixing method.

With the pellicle frame 1, the pellicle 5, and the exposure plate with a pellicle 7 of the present invention as above, particles such as the fine dust particles on the surface of the pellicle frame are remarkably reduced compared with conventional products, and the particles having a risk of falling thereafter can be reduced. Therefore, the present invention can provide a pass in the foreign-matter inspection step etc. in each stage and can prevent occurrence of problems during photolithography caused by the particles adhering to the surface.

Next, a flow of the method for producing a pellicle frame of the present invention that can produce the pellicle frame 1 as above will be described.

First, a material of pure titanium or a titanium alloy is prepared, and mechanically processed into the shape of the pellicle frame.

Thereafter, mechanical scratches and burrs on the surface generated by the mechanical processing are removed by a mechanically polishing treatment (physically polishing treatment). Examples of the method for mechanically polishing include a barrel polishing treatment and a magnetic polishing treatment. The magnetic polishing is more preferable because abrasive grains and media hardly remain on the frame surface. Alternatively, the method constituted by only a combination of these treatments may be acceptable.

The methods for the magnetic polishing treatment and the barrel polishing treatment are not particularly limited, and known methods may be used.

As an example of the magnetic polishing treatment, the pellicle frame is fed into a PP container containing cleaning water (for example, a mixed liquid of a surfactant and water) and a magnetic medium (for example, a bar made of SUS), and a permanent magnet placed in the lower part of the PP container is rotated with a motor. This moves the magnetic medium in the PP container to allow the magnetic medium to collide with and polish the pellicle frame.

As an example of the barrel polishing treatment, the pellicle frame is fed into a container containing cleaning water and a medium, and the container is rotated, revolved, or vibrated, or a turntable placed at a bottom center of the container is rotated like a laundry machine. This allows the medium to collide with and polish the pellicle frame.

After the mechanically polishing treatment, the pellicle frame is subjected to an electrolytic degreasing treatment. The method for the electrolytic degreasing treatment is not particularly limited, and known methods may be used. For example, energization is performed with the work as a negative electrode or a positive electrode in an alkali degreasing liquid, and a stirring action of gas generated from the work surface can be utilized to effectively remove oil contents, scales, adsorbed dust, etc. that adhere to the surface.

If an organic substance adheres to the frame surface after the mechanically polishing treatment, dissolution of a base material by a chemical polishing treatment as described later becomes uneven, which may cause unevenness. Thus, the electrolytic degreasing treatment as above is provided before the chemical polishing treatment can effectively remove the organic substance to improve surface smoothness after the chemical polishing treatment.

Subsequently, the pellicle frame is subjected to the chemically polishing. The method for the chemically polishing is not particularly limited, and known methods may be used. Examples thereof include: a chemical polishing treatment using an acidic or alkaline chemical liquid having dissolving power; and an electrolytic polishing treatment using an electrolyte liquid.

When the frame, specifically the frame made of titanium, is subjected to the chemically polishing treatment, crystal structure precipitates on the surface to generate crystal grain boundary. Although depending on the property of the base material of the frame, a stronger condition of the chemically polishing treatment typically tends to cause a larger step of unevenness or a larger step between the crystals generated near the crystal grain boundary. So that the height or depth of the step of unevenness or the step between the crystals of this crystal grain boundary generated on the surface is reduced to specifically 5 µm or less as noted above, conditions of the mechanical processing into the frame shape, the mechanically polishing treatment, and the chemically polishing treatment may be appropriately regulated. Reduction within the above numerical range is preferable because the effect on the foreign matter inspection can be more reduced.

The pellicle frame 1 of the present invention can be produced as above, and this pellicle frame may be subjected to other treatments such as a coloring treatment. In this case, performing the chemically polishing treatment in the final step can easily remove the particles, even if adhering to the pellicle frame surface in the previous step.

For a purpose of removing polishing residue, machine oil, etc., a cleaning step for the frame may be appropriately added in the middle of or before or after the mechanical processing, the mechanically polishing treatment, the electrolytic degreasing treatment, and the chemically polishing treatment. The cleaning method is not particularly limited, and known methods may be used. Examples thereof include: degreasing cleaning using an alkali aqueous solution, a neutral detergent, etc.; and ultrasonic-wave cleaning using pure water.

In the exposure method of the present invention, exposure is performed by using the above exposure plate with a pellicle. The method for producing a semiconductor device or a liquid-crystal display panel of the present invention includes a step of exposing a substrate (a semiconductor wafer or a plate for liquid crystal) with the above exposure plate with a pellicle. For example, in a lithography step, which is one of the producing steps for a semiconductor device or a liquid-crystal display panel, the above exposure plate with a pellicle is placed on a stepper for exposure in order to form a photoresist pattern corresponding to an integrated circuit etc. on the substrate. For EUV exposure, a projection optical system in which EUV light is reflected on the exposure plate and introduced onto the substrate is commonly used, and these are performed under a reduced pressure or in vacuo. According to this configuration, even if foreign matters adhere onto the pellicle in the lithography step, these foreign matters do not form an image on the wafer on which a photoresist is applied, and thus short circuit, disconnection, etc. of the integrated circuit etc. due to an image of the foreign matters can be prevented. Therefore, use of the exposure plate with a pellicle can increase an yield of the lithography step.

### EXAMPLE

Hereinafter, the present invention will be more specifically described with showing Examples and Comparative Examples of the present invention, but the present invention is not limited thereto.

### (Example)

A pellicle frame (outer size: 150 mm × 118 mm × 1.5 mm, frame width: 4.0 mm, surface area: 68 cm²) was prepared with titanium.

The produced pellicle frame made of titanium was fed inside a PP container in which cleaning water (specifically, cleaning liquid G100 for magnetic polishing, available from PRIORITY Company) and a magnetic medium (made of SUS) were placed, and a magnetic polishing treatment was performed. A motor-driven permanent magnet is placed on a lower part of the PP container. The permanent magnet was rotated with the motor to move the magnetic medium, and allowed this magnetic medium to collide with the pellicle frame to perform the magnetic polishing treatment.

The frame after the magnetic polishing treatment was cleaned with pure water, and then an electrolytic degreasing treatment was performed at a voltage of 6 V for 5 minutes by using a NaOH solution at a concentration of 10 g/L.

Thereafter, the frame was immersed in a chemical polisher liquid (specifically, TCP-08, available from MITSUBISHI GAS CHEMICAL COMPANY, INC.), and a chemical polishing treatment was performed.

The frame after the chemical polishing treatment was cleaned with pure water, then immersed again in pure water, and ultrasonic wave cleaning was performed for 5 minutes.

Thereafter, the frame was immersed again in pure water, and ultrasonic wave cleaning was performed under a pressure-reduced environment for 30 minutes.

The frame after the ultrasonic wave cleaning was cleaned with pure water, then subjected to air blow, and then dried.

The frame after the above steps was subjected to in-liquid particle evaluation described below.

First, 3 L of pure water was poured into a glass beaker subjected to ultrasonic wave cleaning with pure water, and 50 ml of the pure water in the glass beaker was tested with an in-liquid particle counter (NP500T, available from NIPPON DENSHOKU INDUSTRIES CO., LTD.) to record the result as a blank value.

Thereafter, the frame was immersed in pure water in the glass beaker, irradiated with ultrasonic wave at an oscillating frequency of 38 kHz for one minute, then the frame was taken out, and 50 ml of the pure water in the glass beaker was tested again with the in-liquid particle counter (the measurement device same as above). A difference between this value and the blank value was recorded as the number of particles caused by the frame.

Note that the number of particles released from the frame into water was estimated with assuming that the particles were uniformly dispersed in water. Table 1 shows the measurement results.

### (Comparative Example 1)

A titanium frame having a shape same as of Example (outer size: 150 mm × 118 mm × 1.5 mm, frame width: 4.0 mm, surface area: 68 cm²) was prepared.

The frame was cleaned with pure water, and then an electrolytic degreasing treatment was performed at a voltage of 6 V for 5 minutes by using a NaOH solution at a concentration of 10 g/L.

The frame after the electrolytic degreasing treatment was cleaned with pure water, then immersed in pure water, and ultrasonic wave cleaning was performed for 5 minutes.

The frame after the ultrasonic wave cleaning was cleaned with pure water, then subjected to air blow, and then dried.

The frame after the above steps (the magnetic polishing treatment, the chemical polishing treatment, nor the ultrasonic wave cleaning under a reduced pressure environment for 30 minutes were not performed, different from Example) was subjected to the in-liquid particle evaluation in the same manner as in Example to obtain the measurement results in Table 1.

### (Comparative Example 2)

A titanium frame having a shape same as of Example (outer size: 150 mm × 118 mm × 1.5 mm, frame width: 4.0 mm, surface area: 68 cm²) was prepared.

The frame was cleaned with pure water, and then an electrolytic degreasing treatment was performed at a voltage of 6 V for 5 minutes by using a NaOH solution at a concentration of 10 g/L.

The frame after the electrolytic degreasing treatment was cleaned with pure water, then immersed in pure water, and ultrasonic wave cleaning was performed for 5 minutes.

Thereafter, the frame was immersed again in pure water, and ultrasonic wave cleaning was performed under a pressure-reduced environment for 30 minutes.

The frame after the ultrasonic wave cleaning was cleaned with pure water, then subjected to air blow, and then dried.

The frame after the above steps (the magnetic polishing treatment nor the chemical polishing treatment were not performed, different from Example) was subjected to the in-liquid particle evaluation in the same manner as in Example to obtain the measurement results in Table 1.

**[Table 1]**

| | Example | Comparative Example 1 | Comparative Example 2 |
|---|---|---|---|
| 1 to 2 µm | 681 | 9335 | 2060 |
| 2 to 3 µm | 14 | 108 | 28 |
| 3 to 5 µm | 25 | 258 | 78 |
| 5 to 15 µm | 6 | 78 | 19 |
| Total | 726 | 9779 | 2185 |
| Number of released particles per cm² of pellicle frame (50 ml of pure water) | 11 | 144 | 32 |
| Total number of particles to be released from 1 cm² of pellicle frame (in terms of 3 L of pure water) | 641 | 8629 | 1928 |

### <As for Particle Number Evaluation>

Table 1 shows the number of particles with each sphere-equivalent diameter and a total value thereof. Table 1 also shows: a value of the total value divided by the surface area of the pellicle frame, "Number of released particles per cm² of pellicle frame (50 ml of pure water"; and a converted value of multiplying the value by 60 (3 L / 50 ml), "Total number of particles to be released from 1 cm² of pellicle frame (in terms of 3 L of pure water)".

As for the number of particles per cm² of the surface area of the pellicle frame in each example, namely "Total number of particles to be released from 1 cm² of pellicle frame (in terms of 3 L of pure water)" in Table 1, Example was 641, and in contrast, Comparative Example 1 was 8629 and Comparative Example 2 was 1928. It is understood from this particle evaluation that the frame of Example remarkably reduces the number of particles, such as fine dust particles, adhering to the surface.

### (Comparative Example 3)

A pellicle frame was produced in the same manner as in Example except that the electrolytic degreasing treatment nor the chemical polishing treatment were not performed, and the in-liquid particle evaluation same as in Example was performed.

The number of particles per cm² of the surface area of the pellicle frame was 10252. This result was considerably bad compared with Example, 641.

This is presumably because the electrolytic degreasing treatment nor the chemical polishing treatment were not performed, and a large amount of organic substances to adhere to the surface and fine dust particles generated in the magnetic polishing treatment remain, which cannot be effectively removed by cleaning with pure water.

### <As for Ion Elution Test>

The pellicle frames of Example and Comparative Examples 1 and 2 were subjected to evaluation of an amount of eluted ions. Specifically, the pellicle frame of each example was placed in a polyethylene bag, 100 ml of pure water was added and the bag was sealed, and the pellicle frame was retained and immersed at 90°C for three hours. The extraction water in which eluted contents from the pellicle frame were extracted as above was analyzed by using an ion chromatograph (ICS-2100, available from Thermo Fisher Scientific K.K.) at a cell temperature of 35°C, column (IonPacAS11-HC) temperature of 40°C, under a condition of 1.5 ml/min.

From the extraction water, acetate ion, formate ion, chloride ion, nitrite ion, nitrate ion, sulfate ion, oxalate ion, phosphate ion, and ammonium ion were detected, and an elution concentration into 100 ml of the pure water per 50 cm² of the surface area of the pellicle frame was determined.

Table 2 shows the obtained results. Quantification limits (lower limits) of the ion chromatograph used for the evaluation vary depending on the ion species, which was 0.01 to 0.001 ppm. The unit for each value in Table 2 was ppb, and "0" means that the ion species was not quantified.

**[Table 2]**

| | [ppb/50cm2] | | | | | | | | |
|---|---|---|---|---|---|---|---|---|---|
| | Acetate | Formate | Cl | NO2 | NO3 | SO4 | Oxalate | PO4 | NH4 |
| Example | 1 | 4 | 0 | 0 | 0 | 0 | 1 | 0 | 7 |
| Comparative Example 1 | 1 | 5 | 0 | 0 | 1 | 1 | 1 | 0 | 9 |
| Comparative Example 2 | 2 | 8 | 0 | 0 | 0 | 0 | 0 | 0 | 9 |

As shown in Table 2, all of Example and Comparative Examples 1 and 2 exhibited low concentrations of the eluted ions, which were good results. With considering together with the results of the particle number evaluation, it is understood that Example yields the high-quality pellicle frame with reduced ions to be generated while extremely reducing the number of particles on the surface.

### <As for Production of Pellicle>

The frame of Example was cleaned with a neutral detergent and pure water. A mixture in which 1 part by mass of a curing agent (PT-56, available from Shin-Etsu Chemical Co., Ltd.) was added into 100 parts by mass of a silicone adhesive (X-40-3264, available from Shin-Etsu Chemical Co., Ltd.) and stirred was applied as a film-side adhesive over an entire periphery of the frame upper end surface so that the thickness was 0.1 mm.

A mixture in which 0.1 part by mass of a curing agent (L-45, available from Soken Chemical & Engineering Co., Ltd.) was added into 100 parts by mass of an acrylic adhesive (SK-Dyne 1499M, available from Soken Chemical & Engineering Co., Ltd.) and stirred was applied as a mask-side adhesive over an entire periphery of the frame lower end surface so that the thickness was 0.1 mm.

Thereafter, the pellicle frame was heated at 100°C for 12 hours to cure the adhesives on the upper and lower end surfaces. Subsequently, an ultrathin silicon film as a pellicle film was crimped with the film-side adhesive formed on the frame upper end surface to complete a pellicle.

### <As for Unevenness on Inner Surface>

Each of the corner parts of the pellicle frame of Example was cut, and steps and unevenness on the inner surface (inner wall surface) of each side were observed by using a laser microscope (3D-measurement laser microscope, LEXT OLS4000, available from Olympus Corporation).

Details of the 3D-measurement laser microscope OLS4000 were as follows.
- LSM part
   Light source: 405-nm semiconductor laser
- Color observation part
   Light source: white LED

The observation method will be described below. First, the four corner parts of the frame were cut with a cutter to produce four frame pieces. The frame piece was mounted on a stage of the microscope so that an inner face of the frame piece faced the objective lens side. Hereinafter, a direction from one corner to one corner is described as "length direction", and a direction from the upper end surface to the lower end surface is described as "thickness direction".

In a center portion in the length direction of the four frame pieces, presence or absence of unevenness or steps present in a crystal grain boundary within a range of 1 cm in the length direction was confirmed with an objective lens with magnification of 20 (MPLAPONLEXT20, measurement region: 640 µm × 640 µm) and zoom magnification of 1. When the length of 1 cm was not able to be kept, several portions were separately observed so that the total length was 1 cm. Use of the objective lens with magnification of 20 can easily observe the crystal grain on the surface, and can observe a wide range. Note that, since an outer edge region of the frame is unsuitable for the observation due to the frame surface easily tilted toward the outer edge and due to presence of burrs and scratches, it is desirable that a region excluding the outer edge region with 10% in the thickness direction be observed.

The height or depth of the step and concave can be measured from an image photographed with the laser microscope. The laser microscope has a property of low height detection ability with a low magnification, and recommended is measurement with high magnification using an objective lens with magnification of 50 or 100.

Here, the image was photographed by using an objective lens with magnification of 50 (MPLAPONLEXT50 measurement region: 256 µm × 256 µm) or an objective lens with magnification of 100 (MPLAPONLEXT100 measurement region: 128 µm × 128 µm) according to the size of the steps and unevenness to be observed. The height or depth of the steps and unevenness was measured by performing step measurement from the photographed image. In the step measurement, one-shot filter (height noise removal, surface correction) was applied in order to remove effects of noise and waviness. A difference between a highest point and a lowest point of the step or unevenness was measured, and confirmed to be 5 µm or less. As above, even if unevenness etc. on the inner surface of the pellicle frame of Example are present, the unevenness etc. have an extremely small height or depth, and it can be said that the quality is good also from this point.

In the observation, the condition for removing noise of height of the unevenness and the surface correction condition were as follows.

### [Condition for Removing Height Noise]

Saw-Like Surface
High Luminance: 4095 interpolation
Low Luminance: 0 interpolation

### [Surface Correction Condition]

### Tilt correction (automatic)

The present description includes the following embodiments.
[1]: A pellicle frame to be included in a pellicle for photolithography, wherein
   the pellicle frame is made of pure titanium or a titanium alloy, and has a surface subjected to:
   a mechanically polishing treatment;
   an electrolytic degreasing treatment; and
   a chemically polishing treatment.
[2]: The pellicle frame of the above [1], wherein, in particle evaluation of immersion in pure water and irradiation with ultrasonic wave for one minute, a number of particles released into the pure water and having a sphere-equivalent diameter of 1 to 15 µm is 1500 or less per cm² of a surface area of the pellicle frame.
[3]: The pellicle frame of the above [1] or [2], wherein unevenness present on an inner surface of the pellicle frame is 5 µm or less.
[4]: The pellicle frame of any one of the above [1] to [3], wherein, in an ion elution test of immersion in pure water at 90°C for three hours and measurement of a concentration of eluted ions, as for elution concentration into 100 ml of the pure water per 50 cm² of a surface area of the pellicle frame,
   acetate ion is 10 ppb or less,
   formate ion is 100 ppb or less,
   Cl ion is 10 ppb or less,
   NO₂ ion is 10 ppb or less,
   NO₃ ion is 10 ppb or less,
   SO₄ ion is 10 ppb or less,
   oxalate ion is 10 ppb or less,
   PO₄ ion is 10 ppb or less, and
   NH₄ ion is 100 ppb or less.
[5]: A method for producing a pellicle frame to be included in a pellicle for photolithography, wherein the pellicle frame is produced by subjecting a surface of a pellicle frame made of pure titanium or a titanium alloy to:
   a mechanically polishing treatment;
   an electrolytic degreasing treatment; and
   a chemically polishing treatment.
[6]: The method for producing a pellicle frame of the above [5], wherein the mechanically polishing treatment includes a magnetic polishing treatment or a barrel polishing treatment, or
   the mechanically polishing treatment is constituted by only a combination of the magnetic polishing treatment and the barrel polishing treatment.
[7]: The method for producing a pellicle frame of the above [6], wherein the magnetic polishing treatment is performed by:
   using a bar-shaped magnetic medium made of SUS in cleaning water in which the pellicle frame is immersed.
[8]: The method for producing a pellicle frame of any one of the above [5] to [7], wherein the chemically polishing treatment includes
   a chemical polishing treatment or an electrolytic polishing treatment.
[9]: A pellicle for photolithography, comprising:
   a pellicle frame; and
   a pellicle film stretched on the pellicle frame,
   wherein the pellicle frame is the pellicle frame of any one of the above [1] to [4].
[10]: An exposure plate with a pellicle, comprising:
   an exposure plate; and
   a pellicle attached to the exposure plate,
   wherein the pellicle is the pellicle of the above [9].
[11]: An exposure method, comprising a step of performing exposure using the exposure plate with a pellicle of the above [10].
[12]: A method for producing a semiconductor device, the method comprising a step of performing exposure using the exposure plate with a pellicle of the above [10].
[13]: A method for producing a liquid-crystal display panel, the method comprising a step of performing exposure using the exposure plate with a pellicle of the above [10].

It should be noted that the present invention is not limited to the above-described embodiments. The embodiments are just examples, and any examples that substantially have the same feature and demonstrate the same functions and effects as those in the technical concept disclosed in claims of the present invention are included in the technical scope of the present invention.

## Claims

1. A pellicle frame to be included in a pellicle for photolithography, wherein
the pellicle frame is made of pure titanium or a titanium alloy, and has a surface subjected to:
a mechanically polishing treatment;
an electrolytic degreasing treatment; and
a chemically polishing treatment.

2. The pellicle frame according to claim 1, wherein, in particle evaluation of immersion in pure water and irradiation with ultrasonic wave for one minute, a number of particles released into the pure water and having a sphere-equivalent diameter of 1 to 15 µm is 1500 or less per cm² of a surface area of the pellicle frame.

3. The pellicle frame according to claim 1, wherein unevenness present on an inner surface of the pellicle frame is 5 µm or less.

4. The pellicle frame according to claim 1, wherein, in an ion elution test of immersion in pure water at 90°C for three hours and measurement of a concentration of eluted ions, as for elution concentration into 100 ml of the pure water per 50 cm² of a surface area of the pellicle frame,
acetate ion is 10 ppb or less,
formate ion is 100 ppb or less,
Cl ion is 10 ppb or less,
NO₂ ion is 10 ppb or less,
NO₃ ion is 10 ppb or less,
SO₄ ion is 10 ppb or less,
oxalate ion is 10 ppb or less,
PO₄ ion is 10 ppb or less, and
NH₄ ion is 100 ppb or less.

5. A method for producing a pellicle frame to be included in a pellicle for photolithography, wherein the pellicle frame is produced by subjecting a surface of a pellicle frame made of pure titanium or a titanium alloy to:
a mechanically polishing treatment;
an electrolytic degreasing treatment; and
a chemically polishing treatment.

6. The method for producing a pellicle frame according to claim 5, wherein the mechanically polishing treatment includes a magnetic polishing treatment or a barrel polishing treatment, or
the mechanically polishing treatment is constituted by only a combination of the magnetic polishing treatment and the barrel polishing treatment.

7. The method for producing a pellicle frame according to claim 6, wherein the magnetic polishing treatment is performed by:
using a bar-shaped magnetic medium made of SUS in cleaning water in which the pellicle frame is immersed.

8. The method for producing a pellicle frame according to any one of claims 5 to 7, wherein the chemically polishing treatment includes
a chemical polishing treatment or an electrolytic polishing treatment.

9. A pellicle for photolithography, comprising:
a pellicle frame; and
a pellicle film stretched on the pellicle frame,
wherein the pellicle frame is the pellicle frame according to any one of claims 1 to 4.

10. An exposure plate with a pellicle, comprising:
an exposure plate; and
a pellicle attached to the exposure plate,
wherein the pellicle is the pellicle according to claim 9.

11. An exposure method, comprising a step of performing exposure using the exposure plate with a pellicle according to claim 10.

12. A method for producing a semiconductor device, the method comprising a step of performing exposure using the exposure plate with a pellicle according to claim 10.

13. A method for producing a liquid-crystal display panel, the method comprising a step of performing exposure using the exposure plate with a pellicle according to claim 10.
